(19)

Europäisches Patentamt

European Patent Office

Office européen des brevets

(11) **EP 4 726 997 A1**

(12) **EUROPEAN PATENT APPLICATION**
published in accordance with Art. 153(4) EPC

(43) Date of publication:
**15.04.2026  Bulletin 2026/16**

(21) Application number: **24850648.7**

(22) Date of filing: **29.05.2024**

(51) International Patent Classification (IPC):
**H02M 7/5387** $^{(2007.01)}$    **H02M 3/156** $^{(2006.01)}$

(52) Cooperative Patent Classification (CPC):
**H02M 1/00; H02M 3/156; H02M 3/157;
H02M 7/5387**

(86) International application number:
**PCT/CN2024/096130**

(87) International publication number:
**WO 2025/030996 (13.02.2025 Gazette 2025/07)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **07.08.2023  CN 202310993565**

(71) Applicant: **Huawei Technologies Co., Ltd.
Shenzhen, Guangdong 518129 (CN)**

(72) Inventor: **PENG, Jiang
Shenzhen, Guangdong 518129 (CN)**

(74) Representative: **Pfenning, Meinig & Partner mbB
Patent- und Rechtsanwälte
Theresienhöhe 11a
80339 München (DE)**

(54) **INVERTER CIRCUIT, CHIP, AND ELECTRONIC DEVICE**

(57)    An inverter circuit, a chip, and an electronic device are disclosed, and relate to the field of electronic device technologies. An inverter circuit (400) includes: a boost circuit (401), an inverter (402), and a reference voltage generation circuit (404); an input end of the boost circuit (401) is configured to couple to a power supply; a first input end of the inverter (402) is coupled to an output end of the boost circuit (401), and an output end of the inverter (402) is configured to couple to a load; an input end of the reference voltage generation circuit (404) is coupled to the output end of the boost circuit (401), and an output end of the reference voltage generation circuit (404) is coupled to a second input end of the inverter (402); and the reference voltage generation circuit (404) is configured to receive a voltage signal ($U_{boost}$) output by the output end of the boost circuit (401), and the reference voltage generation circuit (404) is further configured to: sample the voltage signal ($U_{boost}$), to generate a reference voltage ($U_{ref}$), and output the reference voltage ($U_{ref}$) to the second input end of the inverter (402), where the reference voltage ($U_{ref}$) includes a voltage generated based on a minimum sampling voltage. In the solution, a high-fidelity high-voltage sinusoidal drive signal can be obtained through the inverter circuit.

FIG. 6

EP 4 726 997 A1

## Description

This application claims priority to Chinese Patent Application No. 202310993565.3, filed with the China National Intellectual Property Administration on August 7, 2023 and entitled "INVERTER CIRCUIT, CHIP, AND ELECTRONIC DEVICE", which is incorporated herein by reference in its entirety.

## TECHNICAL FIELD

This application relates to the field of electronic device technologies, and in particular, to an inverter circuit, a chip, and an electronic device.

## BACKGROUND

As electronic devices such as mobile phones, smart wearable products, and personal computers (personal computers, PCs) gradually develop toward lightness, thinness, and miniaturization, higher requirements are imposed on performance and a volume of a heat dissipation module of the electronic device. Due to superior heat dissipation effect of liquid cooling, it is usually used for dissipating heat from the electronic device. A liquid cooling module may include a pump and a working substance. The working substance (working substance) may be understood as a carrier for mutual conversion between thermal energy and mechanical energy. The pump may be used as a power source of the working substance to provide power for flowing of the working substance. In a flowing process, the working substance may be used as a carrier for heat transfer, so that the liquid cooling module can achieve heat dissipation effect.

A typical liquid cooling module uses a piezoelectric liquid pump as a power source of a working substance. However, the piezoelectric liquid pump needs to be driven by a high-voltage sine wave. Therefore, how to obtain a high-fidelity high-voltage sinusoidal drive signal becomes a problem that needs to be resolved.

## SUMMARY

This application discloses an inverter circuit, a chip, and an electronic device, to obtain a high-fidelity high-voltage sinusoidal drive signal through the inverter circuit.

According to a first aspect, an inverter circuit is provided. The inverter circuit includes: a boost circuit, an inverter, and a reference voltage generation circuit. An input end of the boost circuit is configured to couple to a power supply. A first input end of the inverter is configured to couple to an output end of the boost circuit, and an output end of the inverter is configured to couple to a load. An input end of the reference voltage generation circuit is configured to couple to the output end of the boost circuit, and an output end of the reference voltage generation circuit is coupled to a second input end of the inverter. The reference voltage generation circuit is configured to receive a voltage signal output by the output end of the boost circuit. The reference voltage generation circuit is further configured to sample the voltage signal, to generate a reference voltage, and output the reference voltage to the second input end of the inverter. The reference voltage is a voltage generated based on a minimum sampling voltage of the voltage signal. The input end of the boost circuit is configured to couple to the power supply, and the first input end of the inverter is coupled to the output end of the boost circuit. Therefore, the boost circuit can boost a direct current voltage $U_{in}$ input by the power supply, to obtain a voltage signal $U_{boost}$ (a rounded-top wave with a direct current offset voltage $U_{offset}$). The voltage signal $U_{boost}$ is output to the inverter, so that an amplitude of an output voltage $U_o$ of the inverter is greater than that of the input direct current voltage $U_{in}$. In addition, the reference voltage generation circuit may sample the voltage signal $U_{boost}$, and output a generated reference voltage $U_{ref}$ to the inverter. The reference voltage $U_{ref}$ is a voltage generated based on the minimum sampling voltage of the voltage signal $U_{boost}$, that is, a lowest point of $U_{boost}$ may be used as the reference voltage $U_{ref}$ (corresponding to the minimum sampling voltage, namely, the direct current offset voltage $U_{offset}$ of the rounded-top wave $U_{boost}$). When the reference voltage $U_{ref}$ is used as a reference ground of an H-bridge inverter to invert $U_{boost}$, the direct current offset voltage $U_{offset}$ of the $U_{boost}$ may be eliminated, and a high-fidelity high-voltage sinusoidal drive signal, namely, $U_o$, is obtained. In addition, because the inverter circuit does not involve a filter circuit, the inverter circuit occupies a small volume or area, and is more conducive to miniaturization of a device.

In a possible implementation, the reference voltage generation circuit includes a voltage tracking circuit coupled between the input end and the output end of the reference voltage generation circuit. The voltage tracking circuit includes an analog-to-digital converter, a first memory, a second memory, a comparator, an AND gate circuit, and a digital-to-analog converter. The analog-to-digital converter is coupled between the input end of the reference voltage generation circuit and the first memory. The first memory is coupled to a first input end of the comparator and a first input end of the AND gate circuit. The second memory is coupled to an output end of the AND gate circuit, the digital-to-analog converter, and a second input end of the comparator. An output end of the comparator is coupled to a second input end of the AND gate circuit. An output end of the digital-to-analog converter is coupled to the output end of the reference voltage generation circuit.

In a possible implementation, the analog-to-digital converter is configured to convert a second sampling voltage of the voltage signal into a second digital signal; the first memory is configured to store the second digital signal; and the second memory is configured to store a first digital signal, where the first digital signal is a digital signal corresponding to a first sampling voltage of the voltage signal. The comparator is configured to compare the first digital signal with the second digital signal, and generate a comparison result; and the AND gate circuit is configured to perform an AND operation on the first digital signal and the comparison result to output an operation result, where a first operation result is generated when a voltage corresponding to the first digital signal is greater than a voltage corresponding to the second digital signal, or a second operation result is generated when the voltage corresponding to the first digital signal is less than the voltage corresponding to the second digital signal. The second memory is configured to: store the second digital signal based on the first operation result, or keep storing the first digital signal based on the second operation result; and the digital-to-analog converter is configured to convert the first digital signal or the second digital signal into an analog voltage, where the reference voltage generation circuit generates the reference voltage based on the analog voltage. In some examples, the first memory may be a first in first out (first in first out, FIFO) memory, and the second memory may be a register. For example, the analog-to-digital converter ADC performs analog-to-digital (AD) conversion on a sampling voltage of the voltage signal $U_{boost}$ to obtain a digital signal B, and stores the digital signal B in the FIFO memory. A value in the register is denoted as a digital signal A. The digital signal A may be a digital signal obtained by performing voltage sampling for a first time before the digital signal B is obtained by sampling the voltage signal $U_{boost}$, or may be a default initial value specified in the register based on experience. Then, the register sends the digital signal A to the comparator, and the FIFO memory sends the digital signal B to the comparator. The comparator compares the digital signal A with the digital signal B to generate a comparison result. The FIFO memory sends the digital signal B to the AND gate circuit, and the comparator sends the comparison result to the AND gate circuit. The AND gate circuit performs an AND operation on the digital signal B and the comparison result to output an operation result. When a voltage corresponding to the digital signal A is greater than a voltage corresponding to the digital signal B, a first operation result is generated. Alternatively, when the voltage corresponding to the digital signal A is less than the voltage corresponding to the digital signal B, a second operation result is generated. The register stores the digital signal B based on the first operation result, or stores the digital signal A based on the second operation result. Then, the digital-to-analog converter DAC converts the digital signal (A or B) stored in the register into an analog voltage. Finally, the reference voltage generation circuit 404 generates a reference voltage $U_{ref}$ based on the analog voltage. In this way, after the voltage signal $U_{boost}$ is sampled in one or more cycles, the digital signal stored in the register is updated to a digital signal corresponding to a minimum sampling voltage.

In a possible implementation, the reference voltage generation circuit further includes a selector switch. A common end of the selector switch is coupled to an output end of the analog-to-digital converter, a first selection end of the selector switch is coupled to the first memory, and a second selection end of the selector switch is coupled to the second memory. In this way, when it is determined that the voltage signal $U_{boost}$ is sampled for a first time, the common end of the selector switch may be controlled to be connected to the second selection end, to transmit the obtained digital signal A to the register. Then, the common end of the selector switch is connected to the first selection end, and the generated digital signal is transmitted to the FIFO memory in sequence in a subsequent voltage sampling process.

In a possible implementation, the circuit further includes a voltage sampling circuit and a voltage amplifier circuit. The voltage sampling circuit is coupled between the input end of the reference voltage generation circuit and the voltage tracking circuit. The voltage amplifier circuit is coupled between the voltage tracking circuit and the output end of the reference voltage generation circuit. The voltage sampling circuit has a first sampling rate, the voltage amplifier circuit has a first amplification rate, and a product of the first amplification rate and the first sampling rate is 1. When sampling the voltage signal $U_{boost}$ output by the boost circuit, the voltage sampling circuit may perform sampling at a sampling rate k1. Because $U_{boost}$ is sampled by using the voltage sampling circuit, a sampling rate k1 of the voltage sampling circuit causes a specific reduction to a voltage amplitude of $U_{boost}$. Therefore, the reduction caused by the voltage sampling circuit needs to be supplemented in a gain manner by using the voltage amplifier circuit at a specific amplification rate k2. Therefore, the sampling rate k1 and the amplification rate k2 have the following relationship: k1*k2=1.

In a possible implementation, the circuit further includes an impedance matching circuit coupled between the voltage amplifier circuit and the output end of the reference voltage generation circuit. The impedance matching circuit is mainly configured to match resistance impedance between the voltage amplifier circuit and impedance of the inverter, to ensure system line impedance matching and ensure that a voltage can be normally transmitted. In some examples, the impedance matching circuit may be a voltage follower.

In a possible implementation, the voltage sampling circuit includes a first resistor and a second resistor. A first end of the first resistor is coupled to the input end of the reference voltage generation circuit, a second end of the first resistor is coupled to a first end of the second resistor, and the second end of the first resistor is further coupled to the voltage tracking circuit. A second end of the second resistor is coupled to the ground. The sampling rate k1=the first resistor R1/the second resistor R2.

In a possible implementation, the amplifier circuit includes a positive feedback amplifier circuit or a negative feedback amplifier circuit.

In a possible implementation, the boost circuit includes a boost circuit.

In a possible implementation, the inverter includes an H-bridge inverter.

According to a second aspect, a chip is provided, including a substrate and an inverter circuit disposed on the substrate. The inverter circuit includes the inverter circuit according to the first aspect and the possible implementations of the first aspect.

According to a third aspect, an electronic device is provided, including a pump and the inverter circuit according to the first aspect and the possible implementations of the first aspect, where the inverter circuit is connected to the pump.

In a possible implementation, the electronic device includes a liquid cooling module, the liquid cooling module includes the pump and a cavity, and the pump is configured to drive a working substance to flow in the cavity.

In a possible implementation, the cavity is disposed in a housing of the electronic device.

For technical problems resolved by the second aspect and the third aspect and the possible implementations of the second aspect to the third aspect and implemented technical effects thereof, refer to the descriptions in the first aspect and the possible implementations of the first aspect. Details are not described again.

## BRIEF DESCRIPTION OF DRAWINGS

FIG. 1 is a diagram of a structure of an electronic device according to an embodiment of this application;

FIG. 2 is a diagram of a driving manner of a piezoelectric liquid pump according to an embodiment of this application;

FIG. 3 is a diagram of a structure of an inverter circuit according to an embodiment of this application;

FIG. 4 is a diagram of a structure of an inverter circuit according to another embodiment of this application;

FIG. 5 is a waveform diagram of $U_{boost}$ according to an embodiment of this application;

FIG. 6 is a diagram of a structure of an inverter circuit according to still another embodiment of this application;

FIG. 7 is a diagram of duty rates of Q1 and Q2 according to an embodiment of this application;

FIG. 8 is a diagram of Q3 to Q6 in an on state according to an embodiment of this application;

FIG. 9 is a diagram of a structure of a voltage tracking circuit according to an embodiment of this application;

FIG. 10 is a diagram of a structure of a voltage tracking circuit according to another embodiment of this application; and

FIG. 11 is a diagram of a structure of a voltage tracking circuit according to still another embodiment of this application.

## DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms "first", "second", and the like in this specification are merely intended for a purpose of description, and shall not be understood as an indication or implication of relative importance or implicit indication of a quantity of indicated technical features. Therefore, a feature limited by "first" or "second" may explicitly or implicitly include one or more features. In the description of this application, unless otherwise specified, "a plurality of" means two or more than two. In addition, in this specification, position terms such as "up" and "down" are defined relative to positions of structures in the accompanying drawings. It should be understood that these position terms are relative concepts used for relative description and clarification, and may correspondingly change according to changes in the positions of the structures.

When being used to describe a three-port switch (which is also referred to as a switching device, for example, a switch transistor or a switching transistor), a "first end" and a "second end" may be connection ends of the switch, and a "control end" may be a control end of the switch. For example, for a MOS (metal-oxide-semiconductor, metal-oxide-semiconductor) transistor, the control terminal may be a gate (gate) of the MOS transistor, the first terminal may be a source (source) of the MOS transistor, and the second terminal may be a drain (drain) of the MOS transistor; or the first terminal may be a drain of the MOS transistor, and the second terminal may be a source of the MOS transistor. In embodiments of this application, each switch may include one switch transistor. However, to reduce, as much as possible, an internal resistance increase caused by a switch connected in series to a line, each switch may also include two or more switch transistors connected in parallel.

The following describes technical solutions in this application with reference to the accompanying drawings.

The electronic device in embodiments of this application may include but is not limited to an electronic device that needs to charge a battery, like a mobile phone, a tablet computer, a notebook computer, an ultra-mobile personal computer (ultra-mobile personal computer, UMPC), a handheld computer, a netbook, a personal digital assistant (personal digital assistant, PDA), a wearable electronic device, or a virtual reality device.

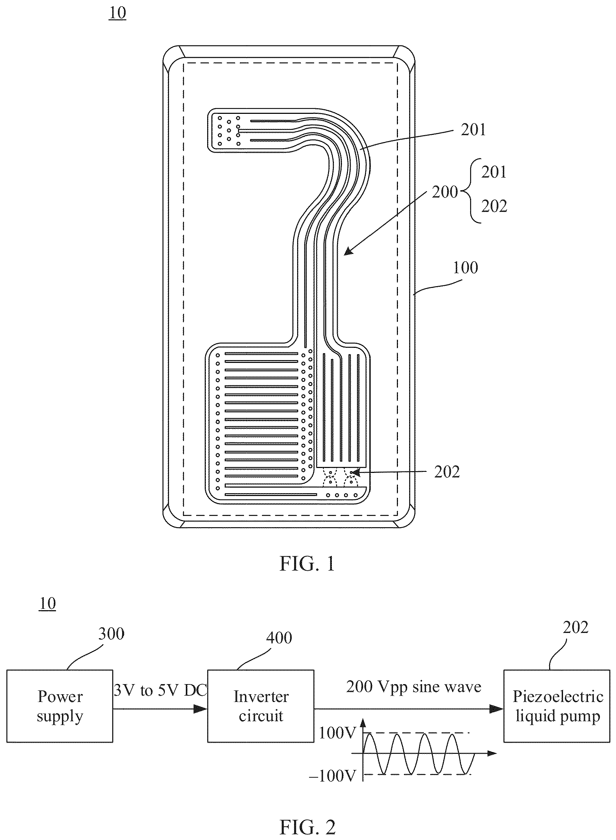

FIG. 1 is a diagram of a structure of an electronic device 10. A mobile phone is used as an example. It can be learned that the electronic device 10 includes a housing 100 and an electronic functional component (not shown in the figure) located in the housing 100. In this embodiment of this application, the mobile phone may be a foldable device or a bar-type device. The electronic functional component of the electronic device 10 includes but is not limited to a processor, an internal memory, a charging management module, a power management module, a battery, an antenna, a communication module, a camera, an audio module, a speaker, a receiver, a microphone, a sensor module, a motor, an indicator, and the like. The electronic device 10 may have more or fewer electronic functional components than those described above. Various electronic functional components may be implemented in hardware, software, or a combination of hardware and software including one or more signal processing and/or application-specific integrated circuits.

The electronic functional component emits heat while in operation. When a temperature inside the electronic device 10 is excessively high, working efficiency of the electronic functional component and a service life of the electronic device 10 are affected. Therefore, a liquid cooling module 200 needs to be disposed to control a temperature rise of the electronic functional component. Based on the foregoing considerations, in some feasible implementations, the liquid cooling module 200 is located between the housing 100 and the electronic functional component, to control a temperature of the electronic functional component. For example, the liquid cooling module 200 may be located on a side of the housing 100 that is close to the electronic functional component. The liquid cooling module 200 may control a temperature of the electronic functional component. In some feasible implementations, the liquid cooling module 200 may also be packaged as a part of the electronic functional component, to control a temperature of the electronic functional component. For example, the liquid cooling module may be packaged in the battery as a part of the battery, to control a temperature of the battery.

The following describes a structure of the liquid cooling module 200.

As shown in FIG. 1, the liquid cooling module 200 may include a cavity 201, a pump 202, and a working substance (not shown in the figure). The working substance is filled in the cavity 201. The pump 202 communicates with the cavity 201, and the pump 202 may be used as a power source of the working substance in the cavity 201, to provide power for flowing of the working substance. In a flowing process, the working substance may be used as a carrier for heat transfer, to take heat away from the electronic functional component, so as to implement control on a temperature of the electronic functional component. In this embodiment of this application, the cavity 201 provides a flowing track/place for flowing of the working substance, and the cavity 201 may be disposed in the housing 100 of the electronic device. A type of the pump 202 is not specifically limited in this embodiment of this application. In some feasible implementations, the pump 202 may be a micro piezoelectric liquid pump. An amplitude of the micro piezoelectric liquid pump is less than or equal to 50 $\mu$m, and the micro piezoelectric liquid pump is ultra-thin, has a small volume, a simple structure, a high pressure, and a small flow rate, has no electromagnetic interference, and has low working noise. The pump can implement precise fluid transmission and control, and is especially suitable for electronic devices such as mobile phones, watches, and accessories.

Generally, the piezoelectric liquid pump needs to be driven by a high-voltage alternating current. To reduce noise generated by the piezoelectric liquid pump, the piezoelectric liquid pump is usually driven by a high-voltage sine wave alternating current. As shown in FIG. 2, because a power supply 300 of the electronic device 10 usually can provide only a direct current (direct current, DC) voltage of 3 V to 5 V, an inverter circuit 400 needs to convert the direct current voltage output by the power supply 300 into a high-voltage sine wave alternating current (as shown in FIG. 2, a peak-to-peak value of the high-voltage sine wave alternating current in the example is 200 Vpp) to drive the piezoelectric liquid pump 202.

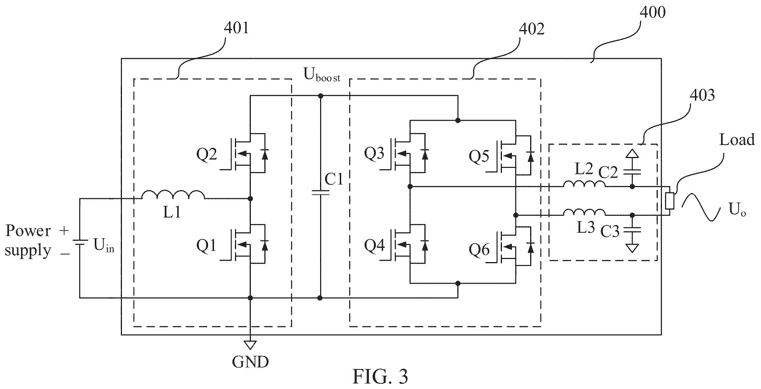

As shown in FIG. 3, a specific circuit structure of the inverter circuit 400 is provided. The inverter circuit 400 includes a boost circuit 401, an inverter 402, and a filter circuit 403. An input voltage $U_{in}$ provided by the power supply is a direct current voltage, and the boost circuit 401 (for example, a boost circuit in FIG. 3) may be first used to boost the input voltage $U_{in}$, to obtain a level-1 high-voltage direct current voltage $U_{boost}$. The high-voltage direct current voltage $U_{boost}$ is used as an input of the inverter 402 (an H-bridge inverter used in FIG. 3). The inverter 402 outputs an SPWM wave by using a sinusoidal pulse width modulation (sinusoidal pulse width modulation, SPWM) policy, and then the SPWM wave passes through the filter circuit 403 (an LC filter circuit used in FIG. 3), to obtain a high-voltage sine wave alternating current as a drive of a load (a piezoelectric liquid pump). Specifically, as shown in FIG. 3, the boost circuit 401 includes an inductor L1, a switch Q1, and a switch Q2. A first end of the inductor L1 is coupled to a positive electrode (+) of the power supply, and a second end of the inductor L1 is coupled to a first end of the switch Q1. A second end of the switch Q1 is coupled to a negative electrode (-) of the power supply, and the negative electrode (-) of the power supply is coupled to the ground GND. A second end of the switch Q2 is coupled to the first end of the switch Q1, and a first end of the switch Q2 serves as an output end of the boost circuit, and controls the switches Q1 and Q2 to be turned on or off at a constant switching frequency through pulse width modulation (PWM). Stable $U_{boost}$ output is implemented by adjusting a duty cycle of a pulse width modulation signal. To ensure stability of an output voltage of the boost circuit, a capacitor C1 is usually coupled between the first end of the switch Q2 and the ground GND. The inverter 402 includes an H-bridge inverter formed by a switch Q3, a switch Q4, a switch Q5, and a switch Q6. A first end of the switch Q3 is coupled to an output end of the boost circuit 401, a second end of the switch Q3 is coupled to a first end of the switch Q4, a second end of the switch Q4 is coupled to the ground GND, a first end of the switch Q5 is coupled to the output end of the boost circuit 401, a second end of the switch Q5 is coupled to a first end of the switch Q6, and a second end of the switch Q6 is coupled to the ground GND. The inverter 402 controls on duty cycles of the switch Q3, the switch Q4, the switch Q5, and the switch Q6 by using a sinusoidal pulse width SPWM modulation policy, and an SPWM wave (where the SPWM wave is a rectangular wave) is output between the second end of the switch Q3 and the second end of the switch Q5. The filter circuit 403 includes an inductor L2, an inductor L3, a capacitor C2, and a capacitor C3, where a first end of the inductor L2 is coupled to a second end of the switch Q3, and a second end of the inductor L2 is coupled to a first end of the load. A first end of the inductor L3 is coupled to a second end of the switch Q5, and a second end of the inductor L3 is coupled to a second end of the load. The capacitor C2 is coupled between the second end of the inductor L2 and the ground GND, and the capacitor C3 is coupled between the second end of the inductor L3 and the ground GND. In this way, the SPWM wave is filtered into a high-voltage sine wave alternating current $U_o$ by using a filtering function of the filter circuit 403. The inverter circuit 400 shown in FIG. 3 includes the filter circuit 403, and the filter circuit 403 mainly includes an inductor and a capacitor. The filter circuit 403 occupies a large volume or area, which is not conducive to miniaturization of an electronic device. In addition, the boost circuit and the six switches of the H-bridge inverter all work in a high-frequency switching state, resulting in a large switching loss and low efficiency.

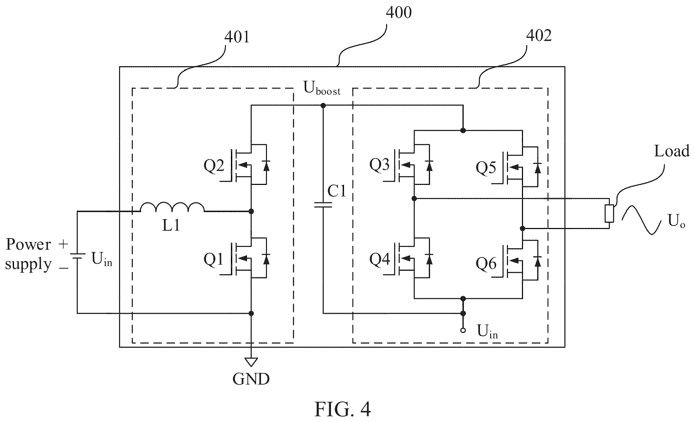

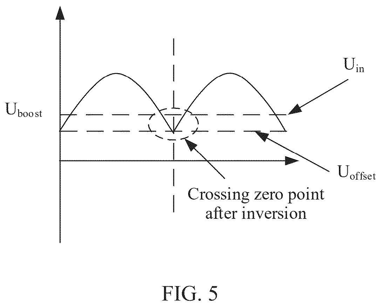

In another example, as shown in FIG. 4, a specific circuit structure of the inverter circuit 400 is provided. The inverter circuit 400 includes the boost circuit 401 and the inverter 402. The boost circuit 401 is the boost circuit in FIG. 3. For a specific connection relationship of the boost circuit 401, refer to the description in FIG. 3. Details are not described again. For a specific connection relationship of the inverter 402 used as the H-bridge inverter, refer to the description in FIG. 3. Details are not described again. A difference from the inverter circuit shown in FIG. 3 lies in that both the second end of the switch Q4 and the second end of the switch Q6 are coupled to a positive electrode (+) of a power supply $U_{in}$, the capacitor C1 is coupled between the first end of the switch Q2 and the second end of the switch Q4, and the second end of the switch Q4 and the second end of the switch Q6 are directly coupled to two ends of the load. In this way, the input voltage $U_{in}$ provided by the power supply is a direct current voltage, and the boost circuit 401 (for example, a boost circuit used in FIG. 4) may be first used to boost the input voltage $U_{in}$, to generate a rounded-top waveform $U_{boost}$ with a direct current offset voltage $U_{offset}$ (as shown in FIG. 5). The rounded-top waveform $U_{boost}$ is used as an input of the inverter 402 (an H-bridge inverter used in FIG. 3). A function of the H-bridge inverter is to invert the rounded-top waveform $U_{boost}$, and the rounded-top waveform $U_{boost}$ is converted into a sine waveform. Therefore, $U_{in}$ is used as a reference ground of the H-bridge inverter, so that a direct current offset of the rounded-top waveform $U_{boost}$ can be approximately eliminated, to obtain a high-voltage sine wave drive signal. In comparison with the solution shown in FIG. 3, no filter circuit needs to be disposed in the inverter circuit shown in FIG. 4, and therefore, the inverter circuit occupies a small volume and area. In addition, the H-bridge inverter is used only to invert the rounded-top waveform $U_{boost}$. Therefore, in comparison with SPWM policy control, switching frequencies of Q3 to Q6 can be reduced, thereby reducing switching losses. However, it may be understood that the component L1, the switch Q1, and the switch Q2 in the boost circuit usually have on-resistance. Therefore, the direct current offset voltage $U_{offset}$ is usually not equal to $U_{in}$. In some examples, as shown in FIG. 5, $U_{in}$ may be greater than the direct current offset voltage $U_{offset}$. When $U_{in}$ is used as a reference ground of the H-bridge inverter to invert the rounded-top waveform $U_{boost}$, there is a large distortion near zero crossing, and a standard sine waveform cannot be generated. Therefore, how to obtain a high-fidelity high-voltage sinusoidal drive signal through the inverter circuit becomes a problem that needs to be resolved.

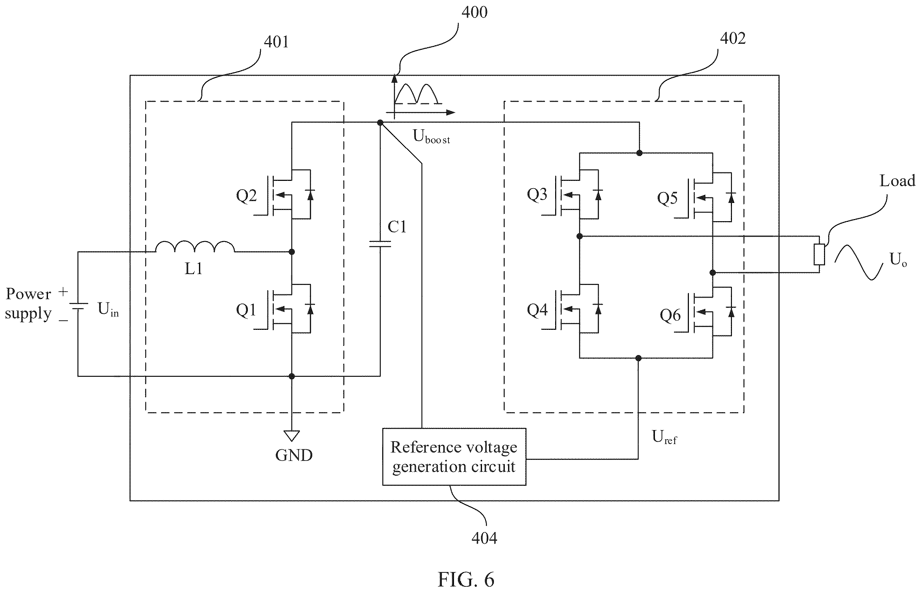

To resolve the foregoing problem, an embodiment of this application provides the inverter circuit 400. As shown in FIG. 6, the inverter circuit 400 includes the boost circuit 401, the inverter 402, and a reference voltage generation circuit 404.

An input end of the boost circuit 401 is configured to couple to a power supply. A first input end of the inverter 402 is configured to couple to an output end of the boost circuit 401. An output end of the inverter 402 is configured to couple to a load. An input end of the reference voltage generation circuit 404 is coupled to the output end of the boost circuit 401, and an output end of the reference voltage generation circuit 404 is coupled to a second input end of the inverter 402. The reference voltage generation circuit 404 is configured to receive a voltage signal output by the output end of the boost circuit 401. The reference voltage generation circuit 404 is further configured to sample the voltage signal, to generate a reference voltage $U_{ref}$, and output the reference voltage $U_{ref}$ to the second input end of the inverter 402. The reference voltage $U_{ref}$ includes a voltage generated based on a minimum sampling voltage.

For example, as shown in FIG. 6, the boost circuit 401 may be a boost circuit. For a specific structure of the boost circuit, refer to FIG. 3. Details are not described herein again. The inverter 402 may be an H-bridge inverter. For a specific structure, refer to FIG. 3. Details are not described again. A difference from FIG. 4 lies in that, in FIG. 6, the first end of the reference voltage generation circuit 404 is coupled to the first end of the switch Q2, and the second end of the reference voltage generation circuit 404 is coupled to the second end of the switch Q4 and the second end of the switch Q6.

In this way, the boost circuit 401 is a main module for implementing that an amplitude of an output voltage of the inverter 402 is greater than an input direct current voltage $U_{in}$. A main function of the boost circuit 401 is to boost the input direct current voltage $U_{in}$ under the action of a controller, to generate a rounded-top waveform $U_{boost}$ with a direct current offset voltage ($U_{offset}$), where the direct current offset voltage is denoted as $V_{offset}$. Refer to the structure of the boost circuit 401 shown in FIG. 6. An expression of an output voltage of the boost circuit 401 is as follows:

$$U_{boost}(t) = \begin{cases} U_{offset} + U_m \sin(\omega t), 0 < \omega t < \pi \\ U_{offset} + U_m \sin(\omega t - \pi), \pi < \omega t < 2\pi \end{cases}$$ , where $U_{offset}$ is the direct current offset voltage,

and $U_m$ is a maximum value max of $U_{boost}$.

The switch Q1 and the switch Q2 of the boost circuit 401 are alternately and complementarily turned on, and a relationship between an output voltage $U_{boost}$ of the boost circuit 401 and a duty cycle D of the switch Q1 is as follows.

$$U_{boost} = \frac{1}{1-D} U_{in}$$

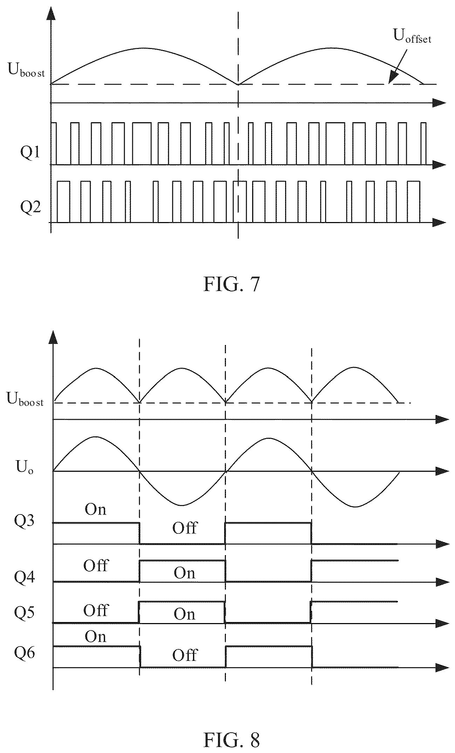

The controller dynamically changes a value of $U_{boost}$ by adjusting the duty cycle D. A diagram of modulation policy (SPWM) and an output voltage $U_{boost}$ of the boost circuit 401 is shown in FIG. 7. $U_{boost}$ is a rounded-top wave with a direct current offset voltage $U_{offset}$.

The reference voltage generation circuit is configured to sample the voltage signal $U_{boost}$, and obtain, as a reference voltage $U_{ref}$ (corresponding to a minimum sampling voltage), a lowest point of $U_{boost}$ after processing, namely, the direct current offset voltage $U_{offset}$ of the rounded-top wave. The reference voltage $U_{ref}$ is used as a reference ground of the H-bridge inverter to invert $U_{boost}$, so that the direct current offset voltage $U_{offset}$ carried by $U_{boost}$ can be eliminated, and a high-fidelity high-voltage sinusoidal drive signal $U_o$ can be obtained. Specifically, as shown in FIG. 8, an operating frequency of the H-bridge inverter is set to be the same as a frequency of $U_o$, Q3 and Q6 are in a same on state (on or off), Q4 and Q5 are in a same on state, and Q3 and Q4 are alternately and complementarily turned on. Because a reference ground of the H-bridge inverter is a reference voltage $U_{ref}$, and a value of the reference voltage $U_{ref}$ is equal to that of $U_{offset}$, after the direct current offset voltage $U_{offset}$ is eliminated, $U_{boost}$ may be converted into a sine wave for outputting.

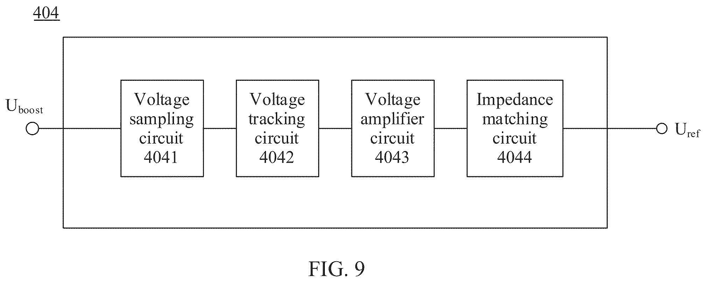

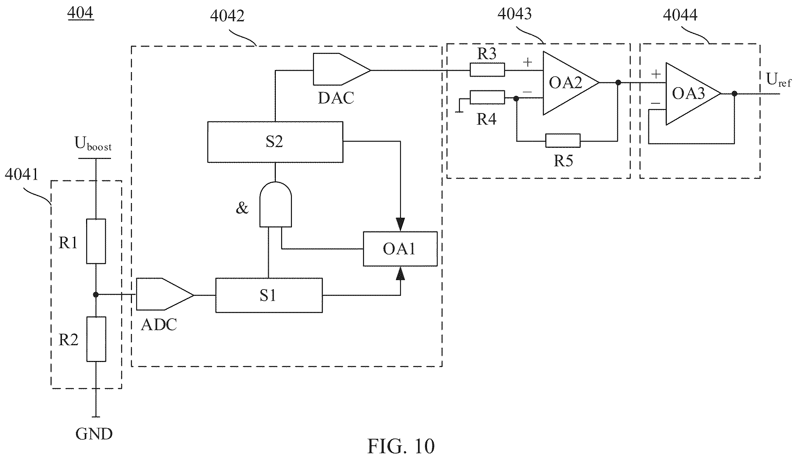

As shown in FIG. 9 and FIG. 10, specific structures of the reference voltage generation circuit 404 are provided. The reference voltage generation circuit 404 includes a voltage tracking circuit 4042 coupled between an input end and an output end of the reference voltage generation circuit 404. The voltage tracking circuit 4042 includes an analog-digital converter (analog-digital converter, ADC), a first memory S1, a second memory S2, a comparator OA1, an AND gate circuit & and a digital-analog converter (digital-analog converter, DAC). The analog-digital converter ADC is coupled between an input end of the reference voltage generation circuit 404 and the first memory S1. The first memory S1 is coupled to a first input end of the comparator OA1 and a first input end of the AND gate circuit &. The second memory S2 is coupled to an output end of the AND gate circuit &, the digital-analog converter DAC, and a second input end of the comparator OA1. An output end of the comparator OA1 is coupled to a second input end of the AND gate circuit &. An output end of the digital-analog converter DAC is coupled to an output end of the reference voltage generation circuit 404. In some examples, the first memory S1 may be a first in first out (first in first out, FIFO) memory, and the second memory S2 may be a register.

In addition, as shown in FIG. 9 and FIG. 10, the reference voltage generation circuit 404 further includes a voltage sampling circuit 4041 and a voltage amplifier circuit 4043. The voltage sampling circuit 4041 is coupled between the input end of the reference voltage generation circuit 404 and the voltage tracking circuit 4042. The voltage amplifier circuit 4043 is disposed between the voltage tracking circuit 4042 and the output end of the reference voltage generation circuit 404. The voltage sampling circuit 4041 has a first sampling rate, the voltage amplifier circuit 4043 has a first amplifier rate, and a product of the first amplification rate and the first sampling rate is 1.

With reference to FIG. 10, the voltage sampling circuit 4041 includes a first resistor R1 and a second resistor R2. A first end of the first resistor R1 is coupled to the input end of the reference voltage generation circuit 404, and is configured to receive a voltage $U_{boost}$ output by the boost circuit 401. A second end of the first resistor R1 is coupled to a first end of the second resistor R2, and the second end of the first resistor R1 is further coupled to the voltage tracking circuit 4042. A second end of the second resistor R2 is coupled to the ground GND. The voltage amplifier circuit 4043 includes a positive feedback amplifier circuit or a negative feedback amplifier circuit. As shown in FIG. 10, the negative feedback amplifier circuit is provided. The negative feedback amplifier circuit includes an operational amplifier OA2. A positive end (+) of the operational amplifier OA2 is coupled to the voltage tracking circuit 4042 through a resistor R3. A negative end (-) of the operational amplifier OA2 is coupled to the ground GND through a resistor R4. An output end of the operational amplifier OA2 is coupled to the negative end (-) of the operational amplifier OA2 through a resistor R5. Because $U_{boost}$ is sampled by using the voltage sampling circuit 4041, a sampling rate (that is, R1/R2) of the voltage sampling circuit 4041 causes a specific reduction to a voltage amplitude of $U_{boost}$. Therefore, the reduction caused by the voltage amplifier circuit 4043 needs to be supplemented in a gain manner by using the voltage amplifier circuit 4043 at a specific amplification rate.

As shown in FIG. 9 and FIG. 10, the reference voltage generation circuit 404 further includes an impedance matching circuit 4044 disposed between the voltage amplifier circuit 4043 and the output end of the reference voltage generation circuit 404. The impedance matching circuit 4044 is mainly configured to match resistance impedance between the voltage amplifier circuit 4043 and impedance of the H-bridge inverter, to ensure system line impedance matching and ensure that a voltage can be normally transmitted. In some examples, the impedance matching circuit 4044 may be a voltage follower OA3. The voltage follower OA3 includes a positive end (+) and a negative end (-). The positive end (+) of the voltage follower is coupled to the output end of the operational amplifier OA2, and an output end of the voltage follower is coupled to the negative end (-) of the voltage follower OA3.

Functions of the reference voltage generation circuit 404 shown in FIG. 9 and FIG. 10 are specifically described as follows.

First, the voltage sampling circuit 4041 samples a voltage signal $U_{boost}$ output by the boost circuit 401. For example, a sampling rate of the voltage sampling circuit 4041 is k1 (that is, R1/R2=k1).

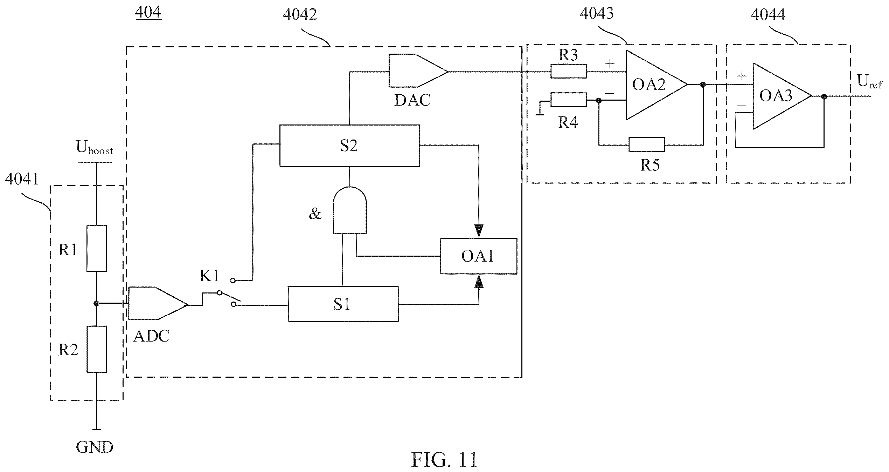

Then, the ADC performs analog-to-digital (AD) conversion on the sampled voltage to obtain a digital signal B, and stores the digital signal B in the FIFO memory S1. A value in the register S2 is denoted as a digital signal A. The digital signal A may be a digital signal obtained through first voltage sampling before the digital signal B is obtained through sampling on a voltage signal $U_{boost}$, or may be a default initial value specified in the register S2 based on experience. It should be noted that, as shown in FIG. 11, the voltage tracking circuit 4042 may include a selector switch K1. A common end of the selector switch K1 is coupled to an output end of the analog-to-digital converter ADC, a first selection end of the selector switch K1 is coupled to the first memory S1, and a second selection end of the selector switch K1 is coupled to the second memory S2. In this way, when it is determined that the voltage signal $U_{boost}$ is sampled for a first time, the common end of the selector switch K1 may be controlled to be connected to the second selection end, to transmit the obtained digital signal A to the register S2. Then, the common end of the selector switch K1 is connected to the first selection end, and the generated digital signal is transmitted to the FIFO memory S1 in sequence in a subsequent voltage sampling process.

Then, the register S2 sends the digital signal A to the comparator OA1, and the FIFO memory S1 sends the digital signal B to the comparator OA1. The comparator OA1 compares the digital signal A with the digital signal B, and generates a comparison result. The FIFO memory S1 sends the digital signal B to the AND gate circuit &, and the comparator OA1 sends the comparison result to the AND gate circuit &. The AND gate circuit & performs an AND operation on the digital signal B and the comparison result, and outputs an operation result. When a voltage corresponding to the digital signal A is greater than a voltage corresponding to the digital signal B, the comparison result may be logic "1". In this case, the AND gate circuit & performs an AND operation on the digital signal B and the logic "1", to generate a first operation result, where the first operation result includes the digital signal B. Alternatively, when a voltage corresponding to the digital signal A is less than a voltage corresponding to the digital signal B, the comparison result may be logic "0". In this case, the AND gate circuit & performs an AND operation on the digital signal B and the logic "0", to generate a second operation result, where the second operation result may include the logic "0". The register S2 stores the digital signal B based on the first operation result, or keeps storing the digital signal A based on the second operation result. Then, the digital-to-analog converter DAC converts the digital signal (A or B) stored in the register S2 into an analog voltage. Finally, the reference voltage generation circuit 404 generates a reference voltage $U_{ref}$ based on the analog voltage. In this way, after the voltage signal $U_{boost}$ is sampled in one or more cycles, the digital signal stored in the register is updated to a digital signal corresponding to a minimum sampling voltage. A process in which the reference voltage generation circuit 404 generates the reference voltage $U_{ref}$ based on the analog voltage includes: The analog voltage is amplified by the voltage amplifier circuit 4043, and an amplification rate of the voltage amplifier circuit 4043 is k2. There is the following relationship: k1*k2=1. An amplified analog signal is output as a reference ground of the H-bridge inverter after impedance matching is performed on the amplified analog signal by the impedance matching circuit 4044, to generate the reference voltage $U_{ref}$.

Optionally, an embodiment of this application further provides a chip, including a substrate and an inverter circuit manufactured on the substrate.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An inverter circuit, comprising:

a boost circuit, wherein an input end of the boost circuit is configured to couple to a power supply;
an inverter, wherein a first input end of the inverter is coupled to an output end of the boost circuit, and an output end of the inverter is configured to couple to a load; and
a reference voltage generation circuit, wherein an input end of the reference voltage generation circuit is coupled to the output end of the boost circuit, and an output end of the reference voltage generation circuit is coupled to a second input end of the inverter, wherein
the reference voltage generation circuit is configured to receive a voltage signal output by the output end of the boost circuit, and the reference voltage generation circuit is further configured to: sample the voltage signal, to generate a reference voltage, and output the reference voltage to the second input end of the inverter, wherein the reference voltage is a voltage generated based on a minimum sampling voltage of the voltage signal.

2. The inverter circuit according to claim 1, wherein the reference voltage generation circuit comprises a voltage tracking circuit coupled between the input end and the output end of the reference voltage generation circuit;

the voltage tracking circuit comprises: an analog-to-digital converter, a first memory, a second memory, a comparator, an AND gate circuit, and a digital-to-analog converter; and

the analog-to-digital converter is coupled between the input end of the reference voltage generation circuit and the first memory, the first memory is coupled to a first input end of the comparator and a first input end of the AND gate circuit, the second memory is coupled to an output end of the AND gate circuit, the digital-to-analog converter, and a second input end of the comparator, an output end of the comparator is coupled to a second input end of the AND gate circuit, and an output end of the digital-to-analog converter is coupled to the output end of the reference voltage generation circuit.

3. The inverter circuit according to claim 2, wherein

the analog-to-digital converter is configured to convert a second sampling voltage of the voltage signal into a second digital signal;

the first memory is configured to store the second digital signal;

the second memory is configured to store a first digital signal, wherein the first digital signal is a digital signal corresponding to a first sampling voltage of the voltage signal;

the comparator is configured to compare the first digital signal with the second digital signal, to generate a comparison result;

the AND gate circuit is configured to perform an AND operation on the first digital signal and the comparison result to output an operation result, wherein a first operation result is generated when a voltage corresponding to the first digital signal is greater than a voltage corresponding to the second digital signal, or a second operation result is generated when the voltage corresponding to the first digital signal is less than the voltage corresponding to the second digital signal;

the second memory is configured to: store the second digital signal based on the first operation result, or keep storing the first digital signal based on the second operation result; and

the digital-to-analog converter is configured to convert the first digital signal or the second digital signal into an analog voltage, wherein the reference voltage generation circuit generates the reference voltage based on the analog voltage.

4. The inverter circuit according to claim 3, wherein the reference voltage generation circuit further comprises a selector switch; and

a common end of the selector switch is coupled to an output end of the analog-to-digital converter, a first selection end of the selector switch is coupled to the first memory, and a second selection end of the selector switch is coupled to the second memory.

5. The inverter circuit according to any one of claims 2 to 4, wherein the inverter circuit further comprises a voltage sampling circuit and a voltage amplifier circuit;

the voltage sampling circuit is coupled between the input end of the reference voltage generation circuit and the voltage tracking circuit;

the voltage amplifier circuit is coupled between the voltage tracking circuit and the output end of the reference voltage generation circuit; and

the voltage sampling circuit has a first sampling rate, the voltage amplifier circuit has a first amplification rate, and a product of the first amplification rate and the first sampling rate is 1.

6. The inverter circuit according to claim 5, further comprising an impedance matching circuit coupled between the voltage amplifier circuit and the output end of the reference voltage generation circuit.

7. The inverter circuit according to claim 5, wherein the voltage sampling circuit comprises a first resistor and a second resistor;

a first end of the first resistor is coupled to the input end of the reference voltage generation circuit; and

a second end of the first resistor is coupled to a first end of the second resistor, the second end of the first resistor is further coupled to the voltage tracking circuit, and a second end of the second resistor is coupled to the ground.

8. The inverter circuit according to claim 5, wherein the voltage amplifier circuit comprises a positive feedback amplifier circuit or a negative feedback amplifier circuit.

9. The inverter circuit according to claim 6, wherein the impedance matching circuit comprises a voltage follower.

10. The inverter circuit according to any one of claims 1 to 9, wherein the boost circuit comprises a boost circuit.

11. The inverter circuit according to any one of claims 1 to 10, wherein the inverter comprises an H-bridge inverter.

12. A chip, comprising a substrate and the inverter circuit according to any one of claims 1 to 11 that is disposed on the substrate.

13. An electronic device, comprising a pump and the inverter circuit according to any one of claims 1 to 11, wherein the inverter circuit is connected to the pump.

14. The electronic device according to claim 13, wherein the electronic device comprises a liquid cooling module, the liquid cooling module comprises the pump and a cavity, and the pump is configured to drive a working substance to flow in the cavity.

15. The electronic device according to claim 14, wherein the cavity is disposed in a housing of the electronic device.

10

201

200 { 201 202

100

202

FIG. 1

10

300

400

202

| Power supply | 3V to 5V DC | Inverter circuit | 200 Vpp sine wave | Piezoelectric liquid pump |

100V

−100V

FIG. 2

FIG. 3

FIG. 4

FIG. 5

FIG. 6

FIG. 7

FIG. 8

404

$U_{boost}$ ○ — Voltage sampling circuit 4041 — Voltage tracking circuit 4042 — Voltage amplifier circuit 4043 — Impedance matching circuit 4044 — ○ $U_{ref}$

FIG. 9

FIG. 10

FIG. 11

EP 4 726 997 A1

## INTERNATIONAL SEARCH REPORT

| | International application No. |
|---|---|
| | **PCT/CN2024/096130** |

**A.   CLASSIFICATION OF SUBJECT MATTER**

H02M7/5387(2007.01)i;  H02M3/156(2006.01)i

According to International Patent Classification (IPC) or to both national classification and IPC

**B.   FIELDS SEARCHED**

Minimum documentation searched (classification system followed by classification symbols)

IPC: H02M

Documentation searched other than minimum documentation to the extent that such documents are included in the fields searched

Electronic data base consulted during the international search (name of data base and, where practicable, search terms used)

CNKI, CNTXT, ENTXT, ENTXTC, VEN: 升压电路, 升压变换, 全桥逆变, 桥式逆变, 正弦, 滤波, 参考电压, 基准电压, 偏置, 开关频率, boost, bridge, invert+, sine, sinusoidal, filter, reference voltage, offset, switching frequency

**C.   DOCUMENTS CONSIDERED TO BE RELEVANT**

| Category* | Citation of document, with indication, where appropriate, of the relevant passages | Relevant to claim No. |
|---|---|---|
| A | CN 107040140 A (SHENZHEN GUOHUA OPTOELECTRONICS CO., LTD. et al.) 11 August 2017 (2017-08-11) <br> description, paragraphs 41-47, and figures 2-3 | 1-15 |
| A | CN 201312267 Y (TBB POWER CO., LTD.) 16 September 2009 (2009-09-16) <br> entire document | 1-15 |
| A | CN 102291028 A (FUZHOU UNIVERSITY) 21 December 2011 (2011-12-21) <br> entire document | 1-15 |
| A | CN 103248258 A (MOBICOOL ELECTRONIC (SHENZHEN) CO., LTD.) 14 August 2013 (2013-08-14) <br> entire document | 1-15 |
| A | CN 110249516 A (PRESIDENT AND FELLOWS OF HARVARD COLLEGE) 17 September 2019 (2019-09-17) <br> entire document | 1-15 |
| A | EP 3098950 A1 (EATON CORP.) 30 November 2016 (2016-11-30) <br> entire document | 1-15 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **22 July 2024** | **07 August 2024** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/096130**

| Patent document cited in search report | | | Publication date (day/month/year) | Patent family member(s) | | | Publication date (day/month/year) |
|---|---|---|---|---|---|---|---|
| CN | 107040140 | A | 11 August 2017 | None | | | |
| CN | 201312267 | Y | 16 September 2009 | None | | | |
| CN | 102291028 | A | 21 December 2011 | None | | | |
| CN | 103248258 | A | 14 August 2013 | CN | 103248258 | B | 08 July 2015 |
| CN | 110249516 | A | 17 September 2019 | KR | 20190109533 | A | 25 September 2019 |
| | | | | KR | 102527046 | B1 | 27 April 2023 |
| | | | | US | 2019379288 | A1 | 12 December 2019 |
| | | | | US | 10666145 | B2 | 26 May 2020 |
| | | | | WO | 2018144866 | A1 | 09 August 2018 |
| | | | | JP | 2020506654 | A | 27 February 2020 |
| | | | | JP | 7166261 | B2 | 07 November 2022 |
| | | | | US | 2021135576 | A1 | 06 May 2021 |
| | | | | US | 11374496 | B2 | 28 June 2022 |
| | | | | WO | 2018144856 | A1 | 09 August 2018 |
| | | | | US | 2020014395 | A1 | 09 January 2020 |
| | | | | US | 10720841 | B2 | 21 July 2020 |
| | | | | EP | 3577751 | A1 | 11 December 2019 |
| | | | | EP | 3577751 | A4 | 25 November 2020 |
| | | | | US | 2020244171 | A1 | 30 July 2020 |
| | | | | US | 10931199 | B2 | 23 February 2021 |
| | | | | IN | 201947034405 | A | 06 September 2019 |
| | | | | CN | 110249516 | B | 11 March 2022 |
| EP | 3098950 | A1 | 30 November 2016 | ES | 2856193 | T3 | 27 September 2021 |
| | | | | EP | 3098950 | B1 | 18 November 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310993565